# EUROPEAN PATENT APPLICATION

(11) **EP 0 655 707 A1**
(43) Date of publication of application: **31.05.1995**
(21) Application number: 93309414.6
(22) Date of filing: 25.11.1993
(51) Int. Cl.: G06K 15/12, H04N 1/191

(54) **Semiconductor laser exposure device**

(71) Applicant: THINK LABORATORY CO., LTD., Kashiwa-City, Chiba-Prefecture (JP)
(72) Inventor: Taniura, Hiroshi, Ibaraki-Prefecture (JP)
(74) Representative: Thomson, Paul Anthony

(57) **Abstract**

A semiconductor laser exposure device, said device having a scanning table (1) on which are mounted a plurality of semiconductor lasers (2) which emit laser beams on to an exposed object W, which lasers (2) are mounted in a row to enable the laser beams to be emitted in parallel, a plurality of optical fibers (3), the number thereof being the same as the number of said semiconductor lasers (2), being placed opposing the semiconducting lasers (2) with one end of the optical fibers (3) being lined up sideways in a row to match the space between each semiconductor laser (2) so that the optical fibers can introduce the laser beams into the fibers, and the other end of the optical fibers also being lined up sideways in a row and being maintained in parallel and close positions, a first condensing lens (4) being mounted a distance A away from the other end of the said optical fibers, a second condensing lens (5) being mounted a distance B away from the first condensing lens (4), and an autofocus lens (6) being mounted a distance C away from the second condensing lens (5), the distance A between the other end of the said optical fibers and the said first condensing lens (4) being determined to enable an appropriate amount of overlapping R to occur between adjacent laser beams when the widened beam of the laser beam emitted from the optical fibers (3) reaches the center part of the said first condensing lens (4), and the distance B between the said first condensing lens (4) and the said second condensing lens (5) being determined at a distance where the focal length (f1) of the first condensing lens (4) and the focal length (f2) of the second condensing lens (5) are added, and the distance C between the second condensing lens (5) and the autofocus lens (6) being determined at a distance where the focal length (f2) of the second condensing lens (5) and the focal length (f3) of the autofocus lens (6) are added, and the distance between the said autofocus lens (6) and the exposed object W being determined to be identical with the focal length (f3) of the autofocus lens (6) after the position of the said scanning table (1) is adjusted in the X-axis direction prior to the exposure, and also such distance is made to be identical with the focal length (f3) of the autofocus lens (6) during the exposure utilising the autofocus function of the autofocus lens (6).

## Description

This invention relates to a semiconductor laser exposure device which enables a plurality of beam exposures to occur by arranging a plurality of laser beams to overlap each other utilising semiconductor lasers.

In conventional semiconductor laser exposure devices, the system adopted is a one laser beam exposure system, wherein one laser beam is emitted on to either a silver chloride film rolled around a drum or on to a plate roll coated with photosensitive film, where the main scanning process (rotation) is conducted on to the drum or the produced roll and at the same time the laser beam conducts sub-scanning (linear movement) along the drum; however, such conventional system requires a long exposure time.

By increasing the number of laser beams, the time required for exposure will be reduced to a few tenths or fractions compared to having only one laser beam, and therefore one may consider increasing the number of laser beams using beam splitters. However, compared to argon-neon gas lasers, semiconductor lasers have a far weaker beam energy, and so it is not possible to transmit the beam through beam splitters. Thus one may consider mounting a plurality of semiconductor lasers in a row; however, the arranged space of the semiconductor lasers would be too large, and there has not been any proposals of how to arrange the laser beams to have them overlap one another.

This invention has for an object the provision of a semiconductor laser exposure device whereby utilising semiconductor lasers, a plurality of laser beams can overlap little by little with adjacent laser beams and a plurality of laser beam exposures can be conducted by transferring the emission direction of the said laser beams to the direction parallel to and crossing the arranged row of the beams and thus greatly reduce the time required for exposure.

According to the present invention there is provided a semiconductor laser exposure device, said device having a scanning table on which are mounted a plurality of semiconductor lasers which emit laser beams on to an exposed object W, which lasers are mounted in a row to enable the laser beams to be emitted in parallel, a plurality of optical fibers the number thereof being the same as the number of said semiconductor lasers, being placed opposing the semiconducting lasers with one end of the optical fibers being lined up sideways in a row to match the space between each semiconductor laser so that the optical fibers can introduce the laser beams into the fibers, and the other end of the optical fibers also being lined up sideways in a row and being maintained in parallel and close positions, a first condensing lens being mounted a distance A away from the other end of the said optical fibers, a second condensing lens being mounted a distance B away from the first condensing lens, and an autofocus lens being mounted a distance C away from the second condensing lens, the distance A between the other end of the said optical fibers and the said first condensing lens being determined to enable an appropriate amount of overlapping R to occur between adjacent laser beams when the widened beam of the laser beam emitted from the optical fibers reaches the center part of the said first condensing lens, and the distance B between the said first condensing lens and the said second condensing lens being determined at a distance where the focal length of the first condensing lens and the focal length of the second condensing lens are added, and the distance C between the second condensing lens and the autofocus lens being determined at a distance where the focal length of the second condensing lens and the focal length of the autofocus lens are added, and the distance between the said autofocus lens and the exposed object W being determined to be identical with the focal length of the autofocus lens after the position of the said scanning table is adjusted in the X-axis direction prior to the exposure, and also such distance is made to be identical with the focal length of the autofocus lens during the exposure utilising the autofocus function of the autofocus lens.

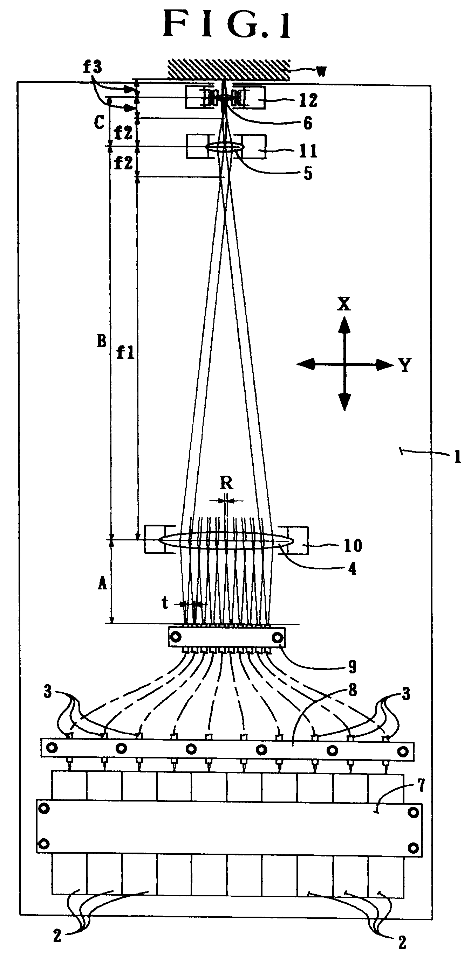

The present invention will be further illustrated by way of example with reference to the accompanying drawing, in which the single figure schematically illustrates a semiconductor laser exposure device in accordance with the invention.

As illustrated, the exposed object W is either a rotative drum rolled with silver chloride film or a plate roll coated with photosensitive film. The said exposed object W will be scanned and rotated by a servo-motor (not shown). Scanning table 1 can be moved freely in the X-axis direction to be closer or further away from the exposed side of the exposed object W, and can be moved freely in the Y-axis direction parallel to the exposed side of the exposed object W. The movement of the scanning table 1 in the Y-axis direction is a sub-scanning, where the table is to move sideways for the space of the laser beam per one rotation of the exposed object W. However, if the exposed object W is, for example, an offset planograph, it is desirable to structure the scanning table 1 as a three-dimensional table. Semiconductor lasers 2,2,... and optical fibers 3,3,..., the first condensing lens 4, the second condensing lens 5 and the autofocus lens 6 are mounted on the said scanning table 1. To enable parallel emittance of the laser beam, ten semiconductor lasers 2,2,... are mounted with fixing equipment 7. Semiconductor lasers 2,2,... are fastened with laser bracers. The number of optical fibers 3,3,... are the same as the number of semiconductor lasers 2,2,... and one end of the optical fibers are lined up in a row sideways to match the space between each semiconductor laser 2,2,... being fixed with fixing equipment 8 and the optical fibers are arranged to face and to be close to the semiconductor lasers and also, to introduce the laser beams into the fibers, the optical fibers are fixed with fixing equipment 9 so that the other end of the optical fibers are lined up in a row sideways and to be maintained in parallel and close together. The first condensing lens 4 is supported by supporting means 10 a distance A away from the other end of the optical fibers 3,3,... and minor adjustment is possible on the supporting means 10. The second condensing lens 5 is supported by supporting means 11 on which minor adjustment is possible, at a distance B away from the first condensing lens 4. Autofocus lens 6 is supported by supporting means 12 on which minor adjustment is possible, at a distance C away from the second condensing lens 5. The laser beams emitted from semiconductor laser array 2 is transmitted through optical fibers 3,3,... and the first condensing lens 4 and the second condensing lens 5 and the autofocus lens 6, and emits on to the exposed object W. Distance A between the optical fibers 3,3,... and the first condensing lens 4 is determined so as to provide an appropriate amount of overlapping R between adjacent laser beams when the beams reach the widened center of the first condensing lens 4, once the light diameter of the laser beams emitted from semiconductor lasers 2a,2a,... becomes cylindrical at a certain size while being transmitted through optical fibers 3,3,... and its light expansion angle is widened while being emitted towards the first condensing lens 4. The said overlap R may be a minor overlap, such as two laser beams just touching each other, but preferably, the range of the overlap should be from 0.293d minimum to 0.5d maximum, wherein the light diameter of the beam is designated as d. Distance B between the first condensing lens 4 and the second condensing lens 5 is determined to be a distance where the focal length f1 of the first condensing lens 4 and the focal length f2 of the second condensing lens 5 are added. Distance C between the second condensing lens 5 and the autofocus lens 6 is determined at a distance where the focal length f2 of the second condensing lens 5 and the focal length f3 of the autofocus lens 6 are added. The distance between the autofocus lens 6 and the exposed object W is designed to be identical with the focal length f3 of the autofocus lens 6 after adjusting the position of the said scanning table 1 in the X-axis direction prior to the exposure. By maintaining the autofocus lens 6 to have its position controlled in the light axis direction either by voice coil or electrical perversion actuator, the distance to be identical with the focal length f3 during the exposure utilising the autofocus function.

In operation, prior to the exposure, the position of the scanning table 1 is adjusted in the X-axis direction, and the distance between the autofocus lens 6 and the exposed object W is set to be identical with the focal length f3 of the autofocus lens 6. Then the exposed object W is scanned and rotated and at the same time scanning table 1 is scanned and moved in the Y-axis direction, and semiconductor lasers 2,2,... are switch driven according to the image data, and the laser beams emitted from semiconductor lasers 2,2,... are introduced into optical fibers 3,3,..., and the diameter of the laser beam becomes cylindrical at a certain size when transmitted through the optical fibers 3,3,... and the expansion angle of the beam is widened when being emitted towards the first condensing lens 4. An appropriate amount of overlapping R will occur with adjacent laser beams when reaching the widened center of the first condensing lens 4, and maintaining the arranged row of overlapping laser beams, the width of the row is reduced to a few tenths or factions by the second condensing lens 5 and autofocus lens 6, and the beams are emitted onto the exposed object W. The laser beams that comprise the overlap array when reaching the widened center of the first condensing lens 4 overlap completely to form one beam at position P which is focal length f1 away from the said first condensing lens 4, and the beam proceeds furthermore for focal length f2 of the second condensing lens 5 to make the beam cross, and transmits through the said second condensing lens 5 and then the beam proceeds furthermore for a distance of focal length f2 of the second condensing lens 5 and is emitted on to the exposed object W. The laser beams emitted from semiconductor laser 2,2,... is emitted on and off on to the exposed object W and expose an image according to the image data.

As explained above, by utilising the semiconductor laser exposure device of the invention, the laser beams emitted from semiconductor lasers are introduced into optical fibers and the space in between the light axes are arranged closely and in parallel, forming an overlap array at the first condensing lens, and, using the second condensing lens and the autofocus lens, the width of the overlap array is reduced to be emitted on to the exposed object W. Accordingly, by utilising semiconductor lasers, a plurality of laser beams can be overlapped little by little sideways in a row, and as the beam emission is transferred in parallel and crossing directions to the array of the said laser beams to produce a plurality of laser beam exposures, and therefore it is possible to reduce the time required for exposure.

## Claims

1. A semiconductor laser exposure device, said device having a scanning table (1) on which are mounted a plurality of semiconductor lasers (2) which emit laser beams on to an exposed object W, which lasers (2) are mounted in a row to enable the laser beams to be emitted in parallel, a plurality of optical fibers (3), the number thereof being the same as the number of said semiconductor lasers (2), being placed opposing the semiconducting lasers (2) with one end of the optical fibers (3) being lined up sideways in a row to match the space between each semiconductor laser (2) so that the optical fibers can introduce the laser beams into the fibers, and the other end of the optical fibers also being lined up sideways in a row and being maintained in parallel and close positions, a first condensing lens (4) being mounted a distance A away from the other end of the said optical fibers, a second condensing lens (5) being mounted a distance B away from the first condensing lens (4), and an autofocus lens (6) being mounted a distance C away from the second condensing lens (5), the distance A between the other end of the said optical fibers and the said first condensing lens (4) being determined to enable an appropriate amount of overlapping R to occur between adjacent laser beams when the widened beam of the laser beam emitted from the optical fibers (3) reaches the center part of the said first condensing lens (4), and the distance B between the said first condensing lens (4) and the said second condensing lens (5) being determined at a distance where the focal length (f1) of the first condensing lens (4) and the focal length (f2) of the second condensing lens (5) are added, and the distance C between the second condensing lens (5) and the autofocus lens (6) being determined at a distance where the focal length (f2) of the second condensing lens (5) and the focal length (f3) of the autofocus lens (6) are added, and the distance between the said autofocus lens (6) and the exposed object W being determined to be identical with the focal length (f3) of the autofocus lens (6) after the position of the said scanning table (1) is adjusted in the X-axis direction prior to the exposure, and also such distance is made to be identical with the focal length (f3) of the autofocus lens (6) during the exposure utilising the autofocus function of the autofocus lens (6).
